# EUROPÄISCHE PATENTANMELDUNG

(11) **EP 4 671 717 A1**
(43) Veröffentlichungstag der Anmeldung: **31.12.2025**
(21) Anmeldenummer: 24183933.1
(22) Anmeldetag: 24.06.2024
(51) Int. Cl.: G01L 3/10

(54) **LENKEN VON MAGNETFELDERN ZUR VERSTÄRKUNG DES MESSSIGNALS VON MAGNETOSTRIKTIVEN DREHMOMENTSENSOREN**

(71) Anmelder: NCTE AG, 82041 Oberhaching (DE)
(72) Erfinder: Eckschlager, Florian, 85521 Riemerling (DE)
(74) Vertreter: Grünecker Patent- und Rechtsanwälte PartG mbB

(57) **Zusammenfassung**

Die Erfindung betrifft einen Drehmomentsensor, umfassend: eine Welle mit einem ersten magnetisierten Bereich, der ein erstes Magnetfeld in Abhängigkeit von einem an der Welle anliegenden Drehmoment erzeugt; einen ersten Magnetfeldsensor zum Erfassen des ersten Magnetfelds, wobei der Magnetfeldsensor ausgebildet ist, ein Signal in Abhängigkeit von einer Stärke des ersten Magnetfelds am Ort des ersten Magnetfeldsensors auszugeben; und eine erste Magnetfeldleitanordnung zum Leiten des ersten Magnetfelds zum Ort des ersten Magnetfeldsensors.

## Beschreibung

### Gebiet der Erfindung

Die Erfindung betrifft einen Drehmomentsensor auf der Grundlage des Effekts der Magnetostriktion. Insbesondere betrifft die Erfindung das Lenken von Magnetfeldern zur Verstärkung des Messsignals von magnetostriktiven Drehmomentsensoren.

### Stand der Technik

Im Stand der Technik sind Drehmomentsensoren bekannt. Ein Beispiel für einen solchen Drehmomentsensor, der auf dem Prinzip des inversen magnetostriktiven Effekts beruht, ist in EP 3 050 790 B1 offenbart. Dabei erzeugt eine magnetisierte Welle in Abhängigkeit von einem anliegenden Drehmoment ein entsprechendes Magnetfeld außerhalb der Welle, das kontaktlos mit einem Magnetfeldsensor erfasst werden kann. Ein solcher magnetostriktiver Drehmomentsensor besteht daher im Wesentlichen aus zwei Komponenten, einerseits einem magnetisierten Bereich der Welle und andererseits dem Magnetfeldsensor zu Erfassung des Magnetfeldes vom magnetisierten Bereich unter Last.

Die Messung von Magnetfeldänderung durch ein Drehmoment kann durch Messspulen in einer Messschaltung erfolgen, die durch das sich veränderte Magnetfeld beeinflusst werden. In einer anderen Variante werden Magnetfeldsensoren auf der Grundlage eines magnetoresistiven Effekts verwendet, die nicht nur die Stärke des Magnetfelds, sondern auch die Richtung des Magnetfelds erfassen können.

Diese Messspulen oder Magnetfeldsensoren werden berührungslos in Relation zur der magnetisierten Welle angebracht (z.B. parallel zur Drehachse) und erfassen Magnetfeldänderungen, die unter Last aufgrund der inversen Magnetostriktion auftreten. Die Magnetfeldänderung ist in der Regel direkt proportional zur äußeren Krafteinwirkung und stellt den Zusammenhang mit dem Drehmoment her. Dazu wird in der Herstellungsphase des Drehmomentsensors eine Kalibrierung durchgeführt.

Weil die Stärken der erzeugten Magnetfelder, insbesondere bei geringen Drehmomenten, am Ort der Messung nur gering sind, kann es zu einem niedrigen Signal-zu-Rausch-Verhältnis kommen, verbunden mit einer entsprechenden Unsicherheit der Drehmomentmesswerte des Drehmomentsensors.

### Beschreibung der Erfindung

Der Erfindung liegt die Aufgabe zugrunde, die genannten Nachteile zumindest teilweise auszuräumen.

Diese Aufgabe wird gelöst durch einen Drehmomentsensor gemäß Patentanspruch 1.

Der erfindungsgemäße Drehmomentsensor umfasst gemäß Patentanspruch 1 die folgenden Merkmale: eine Welle mit einem ersten magnetisierten Bereich, der ein erstes Magnetfeld in Abhängigkeit von einem an der Welle anliegenden Drehmoment erzeugt; einen ersten Magnetfeldsensor zum Erfassen des ersten Magnetfelds, wobei der Magnetfeldsensor ausgebildet ist, ein Signal in Abhängigkeit von einer Stärke des ersten Magnetfelds am Ort des ersten Magnetfeldsensors auszugeben; und eine erste Magnetfeldleitanordnung zum Leiten des ersten Magnetfelds zum Ort des ersten Magnetfeldsensors.

Durch das gezielte Lenken (Führen) der Magnetfelder zur Messstelle wird das magnetische Signal in diesem Bereich gebündelt und verstärkt. Somit kann die Genauigkeit des Drehmomentsensors verbessert werden.

Der erfindungsgemäße Drehmomentsensor kann wie folgt weitergebildet werden.

Eine Weiterbildung besteht darin, dass der Drehmomentsensor weiterhin umfassen kann: einen zweiten magnetisierten Bereich, der ein zweites Magnetfeld in Abhängigkeit von einem an der Welle anliegenden Drehmoment erzeugt, wobei die Magnetisierung des zweiten magnetisierten Bereichs entgegengesetzt zur Magnetisierung des ersten magnetisierten Bereichs ist; einen zweiten Magnetfeldsensor zum Erfassen des zweiten Magnetfelds, wobei der zweite Magnetfeldsensor ausgebildet ist, ein Signal in Abhängigkeit von einer Stärke des zweiten Magnetfelds am Ort des zweiten Magnetfeldsensors auszugeben; und eine zweite Magnetfeldleitanordnung zum Leiten des zweiten Magnetfelds zum Ort des zweiten Magnetfeldsensors.

Die Bereitstellung eines zweiten magnetisierten Bereichs, wobei die Magnetisierung des zweiten magnetisierten Bereichs entgegengesetzt zur Magnetisierung des ersten magnetisierten Bereichs ist, ermöglicht eine gute Korrektur des Signals im Hinblick auf Fremdmagnetfelder. Auf diese Weise kann die Genauigkeit gesteigert werden und insbesondere können konstante, vom angelegten Drehmoment unabhängige Störmagnetfelder kompensiert werden. Dabei wird das Magnetfeld vom zweiten Bereich mit der zweiten Magnetfeldleitanordnung zum Ort des zweiten Magnetfeldsensors gelenkt und dort verstärkt.

Es können jedoch auch noch ein oder mehrere weitere magnetisierte Bereiche vorgesehen sein, wie zum Beispiel ein dritter magnetisierter Bereich.

Gemäß einer anderen Weiterbildung kann die erste Magnetfeldleitanordnung ein erstes und ein zweites Magnetfeldleitelement umfassen, wobei das erste und zweite Magnetfeldleitelement auf jeweils verschiedenen Seiten, insbesondere gegenüberliegenden Seiten des ersten Magnetfeldsensors angeordnet sind. Dies verbessert die beidseitige Bündelung des Magnetfelds vom ersten Bereich am Ort des ersten Magnetfeldsensors.

Eine andere Weiterbildung besteht darin, dass die zweite Magnetfeldleitanordnung ein drittes und ein viertes Magnetfeldleitelement umfassen kann, wobei das dritte und vierte Magnetfeldleitelement auf jeweils verschiedenen Seiten, insbesondere gegenüberliegenden Seiten des zweiten Magnetfeldsensors angeordnet sind. Die zuvor genannten Vorteile gelten hier entsprechend, also die beidseitige Bündelung des Magnetfelds vom zweiten Bereich am Ort des zweiten Magnetfeldsensors.

Dies kann dahingehend weitergebildet werden, dass das zweite und dritte Magnetfeldleitelement zwischen dem ersten und dem zweiten Magnetfeldsensor vorgesehen und einstückig ausgebildet sind.

Gemäß einer anderen Weiterbildung kann jedes der Magnetfeldleitelemente jeweils ein Blech umfassen. Auf diese Weise kann das Magnetfeld präzise zum Magnetfeldsensor geleitet / geführt werden. Dabei kann das Magnetfeld innerhalb des Bleches im Wesentlichen der Richtung des Bleches folgen und an Kanten oder Biegungen wieder heraustreten, um zum Magnetfeldsensor zu gelangen.

Dies kann dahingehend weitergebildet werden, dass jedes Blech eben ausgebildet ist oder ein an den ersten Magnetfeldsensor angrenzender Endabschnitt des jeweiligen Blechs abgewinkelt ausgebildet ist. Somit kann das vom Blech geführte / geleitete Magnetfeld zum Magnetfeldsensor gelangen.

Eine andere Weiterbildung besteht darin, dass das jeweilige Blech in einer Blechebene rechteckig oder zum Magnetfeldsensor hin konisch zulaufend ausgebildet ist, mit anderen Worten keilförmig in Richtung des Magnetfeldsensors. Dies verstärkt weiter die Bündelung des Magnetfelds am Ort des Magnetfeldsensors.

Gemäß einer anderen Weiterbildung kann ein Material der ersten bzw. ersten und/oder zweiten Magnetfeldleitanordnung ein weichmagnetisches oder ein paramagnetisches Material umfassten. Dies ist dahingehend vorteilhaft, dass eine mögliche permanente Magnetisierung der Bleche und Hysterese-Effekte vermieden werden können.

Dies kann dahingehend weitergebildet werden, dass das Material der ersten bzw. ersten und/oder zweiten Magnetfeldleitanordnung ein Metall oder einen keramischen Werkstoff mit magnetisierbaren Metallpartikeln oder einen Kunststoff mit magnetisierbaren Metallpartikeln umfassen kann.

Eine andere Weiterbildung besteht darin, dass der erste und/oder der zweite Magnetfeldsensor ein oder mehrere Spulen umfasst oder ein Sensor auf Basis eines magnetoresistiven Effekts ist/sind, insbesondere ein AMR-Sensor, CMR-Sensor, GMR-Sensor, TMR-Sensor oder ein Sensor auf Basis des planaren Halleffekts ist. Diese Magnetfeldsensoren haben sich als vorteilhaft für die Messung der Magnetfelder erwiesen, da insbesondere deren Empfindlichkeit vergleichsweise hoch ist.

Der erste und/oder der zweite Magnetfeldsensor können auf einer Leiterplatte angeordnet sein.

Weitere Merkmale und beispielhafte Ausführungsformen sowie Vorteile der vorliegenden Erfindung werden nachfolgend anhand der Zeichnungen näher erläutert. Es versteht sich, dass die Ausführungsformen nicht den Bereich der vorliegenden Erfindung erschöpfen. Es versteht sich weiterhin, dass einige oder sämtliche der im Weiteren beschriebenen Merkmale auch auf andere Weise miteinander kombiniert werden können.

### Kurzbeschreibung der Zeichnungen

- Fig. 1: zeigt eine Ausführungsform des erfindungsgemäßen Drehmomentsensors mit Blechen als Magnetfeldleitanordnung.
- Fig. 2: zeigt verschiedene Ausgestaltungen der Bleche gemäß Fig. 1.
- Fig. 3: zeigt weitere Ausgestaltungen der Bleche gemäß Fig. 1 oder 2.
- Fig. 4: zeigt eine Ausführungsform mit senkrecht angeordneten Sensoren.

### Ausführungsformen

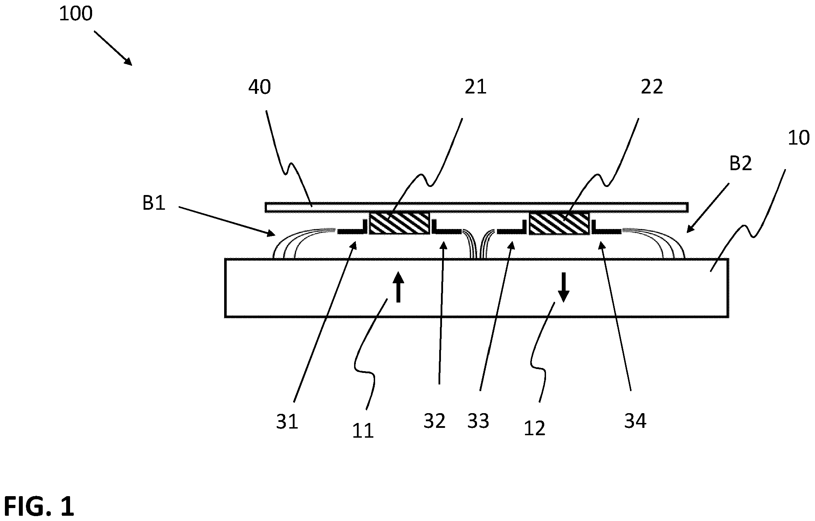

Figur 1 zeigt eine Ausführungsform 100 des erfindungsgemäßen Drehmomentsensors.

Der erfindungsgemäße Drehmomentsensor 100 umfasst eine Welle 10 mit einem ersten magnetisierten Bereich 11, der ein erstes Magnetfeld B1 in Abhängigkeit von einem an der Welle 10 anliegenden Drehmoment erzeugt; einen ersten Magnetfeldsensor 21 zum Erfassen des ersten Magnetfelds B1, wobei der Magnetfeldsensor 21 ausgebildet ist, ein Signal in Abhängigkeit von einer Stärke des ersten Magnetfelds B1 am Ort des ersten Magnetfeldsensors 21 auszugeben; und eine erste Magnetfeldleitanordnung 31, 32 zum Leiten des ersten Magnetfelds B1 zum Ort des ersten Magnetfeldsensors 21.

Der Drehmomentsensor 100 umfasst weiterhin einen zweiten magnetisierten Bereich 12, der ein zweites Magnetfeld B2 in Abhängigkeit von einem an der Welle 10 anliegenden Drehmoment erzeugt, wobei die Magnetisierung des zweiten magnetisierten Bereichs 12 entgegengesetzt zur Magnetisierung des ersten magnetisierten Bereichs 11 ist. Die Magnetisierungen sind dabei in entgegengesetzten Umfangsrichtungen der Welle 10 durch Vormagnetisierung eingeprägt. Ein zweiter Magnetfeldsensor 22 ist zum Erfassen des zweiten Magnetfelds B2 vorgesehen, wobei der zweite Magnetfeldsensor 22 ausgebildet ist, ein Signal in Abhängigkeit von einer Stärke des zweiten Magnetfelds B2 am Ort des zweiten Magnetfeldsensors 22 auszugeben. Eine zweite Magnetfeldleitanordnung 33, 34 leitet das zweite Magnetfeld B2 zum Ort des zweiten Magnetfeldsensors 22.

Der erste und der zweite Magnetfeldsensor sind auf einer Leiterplatte 40 angeordnet.

Die erste Magnetfeldleitanordnung 31, 32 umfasst ein erstes Magnetfeldleitelement 31 und ein zweites Magnetfeldleitelement 32. Die zweite Magnetfeldleitanordnung 33, 34 umfasst ein drittes Magnetfeldleitelement 33 und ein viertes Magnetfeldleitelement 34.

Die Magnetfeldleitelemente sind jeweils als Blech 31, 32, 33, 34 ausgeformt.

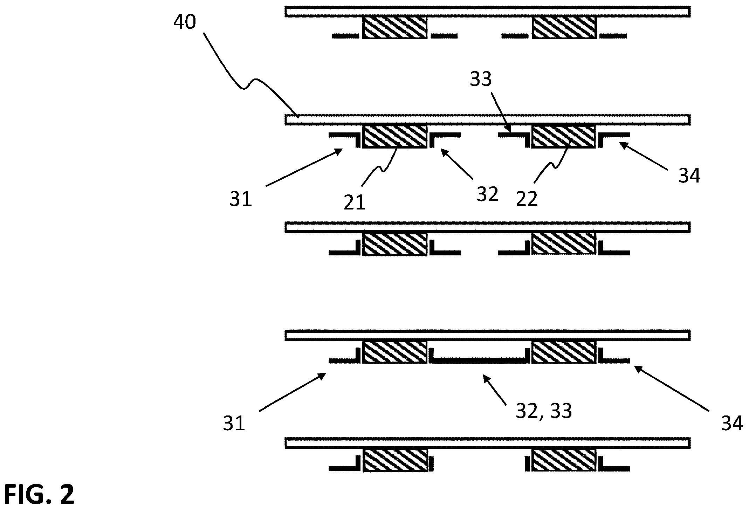

Figur 2 zeigt verschiedene Ausgestaltungen der Bleche gemäß Fig. 1.

Die Bleche können in einer Ebene sein (erste Abbildung) oder jeweils an den Sensoren 21, 22 abgewinkelt nach unten (zweite Abbildung) oder oben (dritte Abbildung) geformt sein.

Das zweite und dritte Blech 32, 33 sind in der vierten Abbildung von oben in einem Stück ausgebildet.

In der fünften Abbildung sind das zweite und dritte Blech 32, 33 jeweils nur in einer Ebene senkrecht zur Leiterplatte ausgeformt.

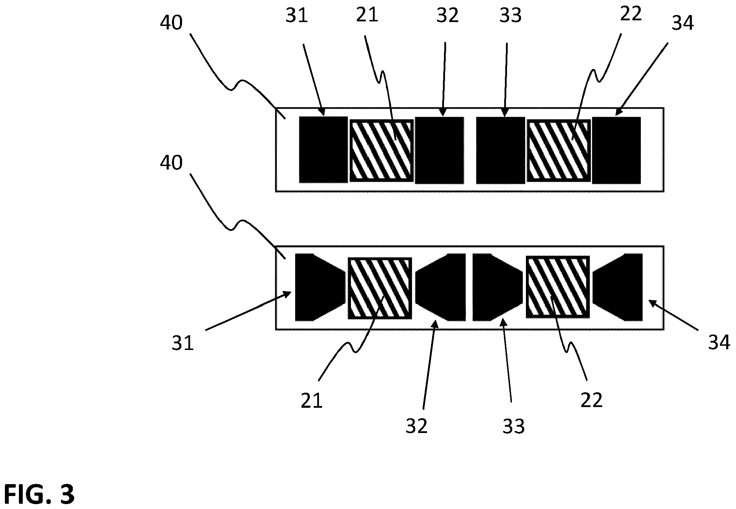

Figur 3 zeigt weitere Ausgestaltungen der Bleche gemäß Fig. 1 oder 2.

In der oberen Abbildung sind die Bleche 31, 32, 33, 34 in der Blechebene rechteckig geformt, während sie in der unteren Abbildung keilförmig in Richtung der Sensoren 21, 22 geformt sind, was das Magnetfeld (bzw. die Magnetfeldlinien) stärker auf die Sensoren 21, 22 bündelt.

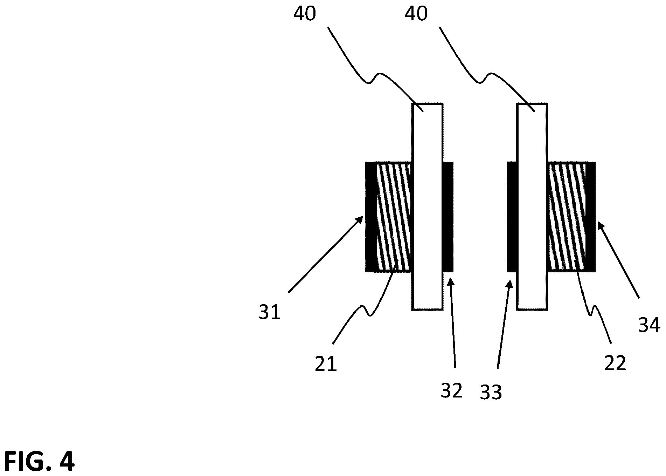

Fig. 4 zeigt eine Ausführungsform mit senkrecht angeordneten Sensoren.

Auch bei dieser Anordnung der Sensoren 21, 22 auf den PCBs 40 können die Magnetfeldlinien durch Bleche 31, 32, 33, 34 geleitet werden, um das Signal zu verbessern.

Die dargestellten Ausführungsformen sind lediglich beispielhaft und der vollständige Umfang der vorliegenden Erfindung wird durch die Ansprüche definiert.

## Patentansprüche

1. Drehmomentsensor, umfassend:
eine Welle mit einem ersten magnetisierten Bereich, der ein erstes Magnetfeld in Abhängigkeit von einem an der Welle anliegenden Drehmoment erzeugt;
einen ersten Magnetfeldsensor zum Erfassen des ersten Magnetfelds, wobei der Magnetfeldsensor ausgebildet ist, ein Signal in Abhängigkeit von einer Stärke des ersten Magnetfelds am Ort des ersten Magnetfeldsensors auszugeben; und
eine erste Magnetfeldleitanordnung zum Leiten des ersten Magnetfelds zum Ort des ersten Magnetfeldsensors.

2. Drehmomentsensor nach Anspruch 1, weiterhin umfassend:
einen zweiten magnetisierten Bereich, der ein zweites Magnetfeld in Abhängigkeit von einem an der Welle anliegenden Drehmoment erzeugt, wobei die Magnetisierung des zweiten magnetisierten Bereichs entgegengesetzt zur Magnetisierung des ersten magnetisierten Bereichs ist;
einen zweiten Magnetfeldsensor zum Erfassen des zweiten Magnetfelds, wobei der zweite Magnetfeldsensor ausgebildet ist, ein Signal in Abhängigkeit von einer Stärke des zweiten Magnetfelds am Ort des zweiten Magnetfeldsensors auszugeben; und
eine zweite Magnetfeldleitanordnung zum Leiten des zweiten Magnetfelds zum Ort des zweiten Magnetfeldsensors.

3. Drehmomentsensor nach Anspruch 1 oder 2, wobei die erste Magnetfeldleitanordnung ein erstes und ein zweites Magnetfeldleitelement umfasst, wobei das erste und zweite Magnetfeldleitelement auf jeweils verschiedenen Seiten, insbesondere gegenüberliegenden Seiten des ersten Magnetfeldsensors angeordnet sind.

4. Drehmomentsensor nach Anspruch 2 oder 3, wobei die zweite Magnetfeldleitanordnung ein drittes und ein viertes Magnetfeldleitelement umfasst, wobei das dritte und vierte Magnetfeldleitelement auf jeweils verschiedenen Seiten, insbesondere gegenüberliegenden Seiten des zweiten Magnetfeldsensors angeordnet sind.

5. Drehmomentsensor nach Anspruch 4, wobei das zweite und dritte Magnetfeldleitelement zwischen dem ersten und dem zweiten Magnetfeldsensor vorgesehen und einstückig ausgebildet sind.

6. Drehmomentsensor nach einem der Ansprüche 3 bis 5, wobei jedes der Magnetfeldleitelemente jeweils ein Blech umfasst.

7. Drehmomentsensor nach Anspruch 6, wobei jedes Blech eben ausgebildet ist oder ein an den ersten Magnetfeldsensor angrenzender Endabschnitt des jeweiligen Blechs abgewinkelt ausgebildet ist.

8. Drehmomentsensor nach Anspruch 5 oder 6, wobei das jeweilige Blech in einer Blechebene rechteckig oder zum Magnetfeldsensor hin konisch zulaufend ausgebildet ist.

9. Drehmomentsensor nach einem der Ansprüche 1 bis 8, wobei ein Material der ersten bzw. ersten und/oder zweiten Magnetfeldleitanordnung ein weichmagnetisches oder ein paramagnetisches Material umfasst.

10. Drehmomentsensor nach Anspruch 9, wobei das Material der ersten bzw. ersten und/oder zweiten Magnetfeldleitanordnung ein Metall oder einen keramischen Werkstoff oder Kunststoff mit magnetisierbaren Metallpartikeln umfasst.

11. Drehmomentsensor nach einem der Ansprüche 1 bis 10, wobei der erste und/oder der zweite Magnetfeldsensor ein oder mehrere Spulen umfasst oder ein oder mehrere Sensoren auf Basis eines magnetoresistiven Effekts umfasst, insbesondere ein AMR-Sensor, CMR-Sensor, GMR-Sensor, TMR-Sensor oder ein oder mehrere Sensoren auf Basis des planaren Halleffekts umfasst.

12. Drehmomentsensor nach einem der Ansprüche 1 bis 11, wobei der erste und/der der zweite Magnetfeldsensor auf einer Leiterplatte angeordnet sind.
